Europäisches Patentamt

European Patent Office

Office européen des brevets

(11) Publication number: **0 273 030**
**A2**

# (12) EUROPEAN PATENT APPLICATION

(21) Application number: 88101734.7

(22) Date of filing: 03.12.83

(51) Int. Cl.⁴: **H 01 L 29/72**

(30) Priority: 13.12.82 US 449321

(43) Date of publication of application:
**29.06.88 Bulletin 88/26**

(84) Designated Contracting States: **DE FR NL**

(60) Publication number of the earlier application in
accordance with Art. 76 EPC: **0 111 803**

(71) Applicant: **GENERAL ELECTRIC COMPANY**
**1 River Road**
**Schenectady New York 12305 (US)**

(72) Inventor: **Baliga, Bantval Jayant**
**3 Clove Court**
**Clifton Park New York 12065 (US)**

(74) Representative: **Schüler, Horst, Dr. et al**
**Kaiserstrasse 69**
**D-6000 Frankfurt/Main 1 (DE)**

(54) Lateral insulated-gate rectifier structures.

(57) Insulated-gate rectifiers of lateral configuration are fabricated with all three device terminals provided on one principal surface. Anode-shorted embodiments are disclosed, as well as embodiments including a buried layer for enhancing device forward conductivity.

Fig. 1

**Description**

## LATERAL INSULATED-GATE RECTIFIER STRUCTURES

### BACKGROUND OF THE INVENTION

The present invention relates generally to insulated-gate rectifiers and, more particularly, to insulated-gate rectifiers of lateral configuration.

Various forms of insulated-gate rectifiers are disclosed in commonly-assigned DE-A-31 47 075.0 by B.J. Baliga and entitled "GATE ENHANCED RECTIFIER". (It may be noted that a "Gate Enhanced Rectifier", or "GERECT", is alternatively referred to herein as an "Insulated-Gate Rectifier", or "IGR". The two terms are intended to means the same device.)

As described in detail in the above-identified DE-A-31 47 075.0 an insulated-gate rectifier (IGR) is a semiconductor device having an insulated gate for controlling current flow between its main terminals, i.e., between its anode and cathode terminals. The gate and conduction channel of an IGR are similar to corresponding elements in a MOSFET (or more generically, an IGFET) with, however, important differences between the two devices (an IGR and a MOSFET) as described in detail in the above-identified DE-A-31 47 075.0.

Structurally, previously-disclosed IGR's are similar to vertical-channel MOSFET's, with an important distinction. In particular, assuming the case of an N-channel device, a P+ (or highly-doped, low-resistivity P-conductivity type) anode region, not found in a MOSFET, is included. A four-layer, i.e. PNPN, device therefore results. Operation also differs from that of a MOSFET, a significant result of which being that the IGR has higher forward conductivity.

Considering the two devices in greater detail, in a conventional N-channel power MOSFET, there is an N (or high resistivity N-conductivity type) drift region forming an extension of the MOSFET drain terminal region. Conduction in such a MOSFET occurs primarily by simple electron current flow through a depletion channel induced in a shield base region by an electric field from an insulated gate electrode, without the presence of excess carriers. Due to the lack of excess carriers, the MOSFET has a relatively fast switching speed.

In contrast, in an IGR, the P+ anode region injects minority carriers (e.g. holes) into the N conductivity type region corresponding to the drift region of a MOSFET. This drift region of an SCR constitutes what, for convenience, is herein termed an "active-base" region, signifying that conduction in this particular region involves more than the mere flow of majority carriers, e.g. electrons. Rather, during operation, the holes introduced into the region herein termed the active-base region recombine with electrons introduced from the cathode, increasing device conductivity. The conduction mode is therefore bipolar in part.

As also described in the above-identified DE-A-31 47 075.0 the IGR differs from a four-layer PNPN thyristor, even though some forms of IGR are structurally superficially somewhat similar to MOS-gated SCR or thyristor structures, and even though an IGR may be considered as including a parasitic SCR. Significantly, in the normal operation of an IGR, the gate electrode maintains both turn-on and turn-off control of current flow through the device, and the parasitic SCR is not permitted to latch into a conducting state.

As further described in the above-identified DE-A-31 47 075.0 to increase turn-off speed, shorts between the device anode and the adjacent N conductivity type active base region may be employed. (For convenience, these shorts are herein termed "anode shorts".) Anode shorts aid in improving turn-off speed of an IGR due to the bipolar conduction mode of an IGR. In particular, during conduction in an IGR, there are excess electrons and holes in the active-base region and, upon turn-off, these excess electrons and holes are momentarily trapped in the active-base region, prolonging device conduction and therefore degrading turn-off speed. Excess holes in the N conductivity type active base region of an IGR exit towards the cathode electrode through the P conductivity type shield base region. However, in the absence of an anode short, there is no similar path for excess electrons in the active base region. The inclusion of anode shorts overcomes this particular shortcoming, with the result that the device turn-off speed is enhanced.

Previous IGR devices as disclosed in the above-identified Baliga Application Serial No. 212,181 comprise vertical-channel structures. For high power switching applications, the vertical-channel structure is optimum. However, the device anode is located at the bottom of the semiconductor wafer. This does not allow isolation of the anode when several IGR devices are integrated on the same chip unless the circuit is restricted to a case where the anodes of all devices are connected together.

By the present invention, lateral IGR structures are provided, with all three device terminals on one surface.

### SUMMARY OF THE INVENTION

Accordingly, it is an object of the invention to provide lateral IGR structures.

It is another object of the invention to provide lateral IGR structures including anode shorts to increase the turn-off speed of the device by rapidly removing majority carriers from the active base region.

It is yet another object of the invention to provide lateral IGR structures including means for enhancing the injection of majority carriers from the device anode region into the active base region for increasing device conductivity.

Briefly stated, and in accordance with one aspect of the invention, an insulated-gate rectifier of lateral configuration includes a body of semiconductor material having a principal surface, and including an active base region of one conductivity type, for example of N conductivity type, extending to the principal surface. Formed in the body within the active base region and extending to the principal surface is a first main terminal structure, in this example an anode terminal structure. The first main terminal structure includes a highly-doped island-like first main terminal region of opposite conductivity type (e.g. P+ conductivity type). A first terminal electrode contacts the first main terminal region.

Also formed in the body within the active base region is a shield base region. The shield base region is laterally spaced from the first main terminal region, defining a drift region lateral width $W_L$ therebetween.

A second main terminal structure, in this example the device cathode terminal, is spaced from the active base region to define a channel portion in the shield base region between the second main terminal structure and a primary region of the active base region. A second terminal electrode contacts the second main terminal region.

The shield base region and the second main terminal structure can be formed in various ways and accordingly comprise any one of various specific structures. For example, a double-diffused MOS (DMOS) fabrication technique may be employed to provide a second main terminal structure confined laterally within a shield base region. As another example, a "V"-groove MOS (VMOS) fabrication technique may be employed.

Positioned over the channel portion is an insulated gate electrode configured for inducing in the channel portion, when gate voltage is applied to the gate electrode, a depleted channel region or inversion layer for conductively coupling the second main terminal structure and the active base region. Typically, the device is normally-off (enhancement mode device) and when gate voltage is applied, an inversion channel region of the one conductivity type extending between the second main terminal structure and the primary region of the active base region is induced through depletion. In this example, a positive gate voltage induces an inversion channel region of N conductivity type, which thus comprises an inversion layer in the P conductivity type shield base region. However, it will be appreciated that normally-on (depletion mode) devices may also be fabricated, in which case the channel portion is normally conducting, and ceases conducting when gate voltage is applied.

In contrast to an SCR, the active base region, the shield base region, and the terminal structures are configured and arranged such that the subject lateral IGR supports conduction in a forward direction between the main terminal electrodes when the conduction channel is induced by gate voltage, and such that the IGR ceases to support conduction in a forward direction when the conduction channel is no longer induced. Thus, significantly, the gate maintains both turn-on and turn-off control of conduction through the device.

The device preferably also includes a conventional short between the device cathode and the adjacent P conductivity type shield base region. For convenience this short is herein termed a "cathode short", and is achieved by allowing the second terminal electrode, i.e., the cathode electrode, to additionally contact the shield base region. As in previous IGR structures, this cathode short aids in inhibiting operation of the parasitic PNPN SCR structure.

In one device embodiment, anode shorts are also included. Although anode shorts have the adverse effect of sacrificing the reverse blocking capability of the device, the anode shorts have the significant advantage of providing faster switching speed. In one particular structure of the invention, a heavily-doped island-like first terminal shorting region of the one conductivity type, i.e. an N+ region, is formed in the body within the active base region and extending to the principal surface. The first terminal electrode additionally contacts the first terminal shorting region to complete the short. Preferably, the first terminal region and the first terminal shorting region overlap.

In accordance with another aspect of the invention, a buried layer is included in the lateral IGR structure for the purpose of enhancing forward current condition. In particular, a heavily-doped buried layer of opposite conductivity type, i.e., a P+ layer, is formed in the body generally below the active base region layer, more specifically, between the active base region layer and a lightly-doped substrate layer. The P+ buried layer underlies both the first main terminal region, i.e., the P+ anode region, and the active base primary region. During forward conduction operation, the buried layer serves to collect majority carriers, i.e. holes, injected from the anode at the buried layer end below the anode region, and to reinject these holes below the active base primary region.

The P+ buried layer of the invention for enhancing conductivity may be employed in lateral device structures with or without an anode short. .

BRIEF DESCRIPTION OF THE DRAWINGS

the novel features of the invention are set forth with particularity in the appended claims, the invention, both as to organization and content, will be better understood and appreciated from the following detailed description taken in conjunction with the drawings, in which:

FIG. 1 is a schematic partial cross-sectional view of a lateral IGR structure in accordance with the invention;

FIG. 2 is a similar cross-sectional view of an anode-shorted IGR structure in accordance with the invention;

FIG. 3 is a similar cross-sectional view of a lateral IGR structure including a P+ conductivity type buried layer for enhancing device conduction;

FIG. 4 is a cross-sectional view of a lateral IGR including a P+ buried layer and an anode short; and

FIG. 5 is a cross-sectional view of a "V"-groove MOS form of device.

DESCRIPTION OF THE PREFERRED
EMBODIMENTS

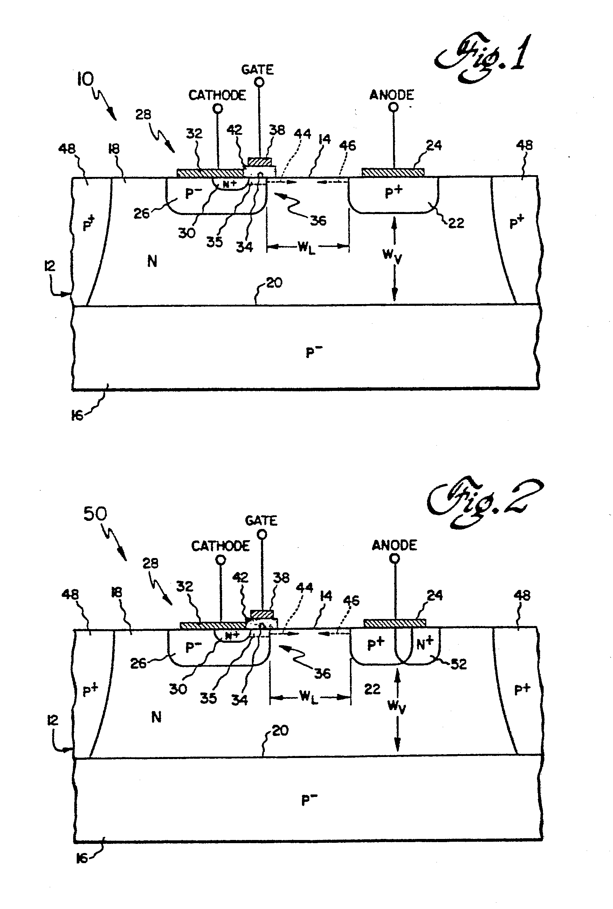

Referring first to FIG. 1, depicted in schematic fashion is an IGR 10 of lateral configuration. FIG. 1 may also be considered as depicting a single unit cell of an overall IGR comprising a plurality of unit cells. The IGR 10 comprises a body of semiconductor material, such as silicon, generally designated 12, and having a principal surface 14. The principal surface 14 is in general the surface at which device connections are made. The body 12 includes a $P^-$ semiconductor substrate 16, i.e. a lightly-doped region of P conductivity type. An active base region layer 18 of N conductivity type is formed over the substrate 16, preferably by means of conventional epitaxial growth techniques, and extends to the principal surface 14. THe substrate layer 16 is thus contiguous at an interface 20 with the portion of the active base region layer 18 opposite the principal surface 14.

An island-like anode P+ terminal region 22, i.e., a highly-doped region of P conductivity type, is formed in the body 12 within the active base region 18 and extends to the principal surface 14. A device anode terminal electrode 24 contacts the anode region 22, in preferably ohmic contact therewith. The region 22 may be formed employing conventional photolithographic masking and gas-source diffusion techniques.

The anode region 22 is spaced from the substrate 16 by a vertical width of distance $W_V$, determined by the thickness of the epitaxial layer comprising the active base 18. To prevent punch-through breakdown of the device 10 during operation, it will be appreciated that the dimension $W_V$ must be greater than the depletion layer width at breakdown.

Also formed in the body 12 within the active base region 18 is an island-like shield base region 26 of $p^-$ conductivity type extending to the principal surface 14 and laterally spaced from the anode region 22 by a drift region lateral width of distance $W_L$. This likewise can be a diffused region. The dimension $W_L$, like $W_V$, must be greater than the depletion layer width at breakdown to prevent punch-through breakdown.

Confined laterally within the shield base region 26 is a device cathode structure, generally designated 28. More particularly, the device cathode structure 28 includes an island-like N+ cathode terminal region 30, i.e. a highly-doped region of N conductivity type, formed in the body 12 within the shield base region 26. It will be appreciated that the shield base 26 and cathode 30 regions may be formed by conventional double-diffusion techniques. A cathode electrode 32 contacts both the cathode region 30 and the shield base region 26, providing a conventional cathode short therebetween. In the IGR 10, this cathode short serves to inhibit operation of the source 30, shield base 26 and active base 18 regions as an NPN bipolar transistor, thus preventing operation of the parasitic PNPN thyristor structure formed by regions 22, 18, 26 and 30 and inherent in the particular IGR 10 structure depicted. A more detailed discussion of a parasitic PNPN structure in the context of a vertical-channel IGR will be found in the above-identified De-A-31 47 075.0.

A portion of the principal surface 14 serves as a channel surface 34. The shield base region 26 then extends to the channel surface 34 in the DMOS device structure depicted.

The second main terminal structure 28 comprising the cathode region 30 and the cathode electrode 32 is spaced from the active base region 18 to define a channel portion 35 within the shield base region 26 just beneath the channel surface 34. The channel portion 35 extends, within the region 26, from the cathode terminal structure 28 to the active base region 18. More specifically, the channel portion extends to a primary region, generally designated 36, of the active base region 18. The primary active base region 36, as the term is employed herein, is that general region of the active base region 18 into which electrons from the cathode region 30 are channeled during device conduction and, as will be appreciated, does not have definite boundaries.

Typical doping concentrations (that is, the number of dopant atoms per cubic centimeter) for the various regions of the IGR 10 are in the order of the following numbers:

The anode region 22: $1 \times 10^{19}$;

The active base region 18: $1 \times 10^{14}$ to $5 \times 10^{15}$;

The shield base region 26: $1 \times 10^{16}$ to $5 \times 10^{18}$; and

The cathode region 30: $> 1 \times 10^{19}$.

While the form of device 10 illustrated in FIG. 1 includes an N+ cathode region 30, such is not strictly necessary in an IGR, as, in an enhancement mode device, a sufficient N conductivity type accumulation region can in some cases be formed in the P conductivity type shield base region 26 by inversion under the influence of an electric field from the gate electrode, which is described next.

In particular, the device 10 additionally includes an insulated gate electrode 38 over the channel portion 35 configured for inducing in the shield base region 26, at the surface 34, when gate voltage is applied thereto, an inversion channel region for controlling conduction in the channel portion 35 to conductively couple the second main terminal structure 28 and the active base region 18. As is known, the voltage applied to the gate electrode 38 region can either cause a normally-conducting channel to cease conducting, or cause a normally non-conducting channel to conduct. In the illustrated embodiment, the latter is the case, and an induced N conductivity type inversion channel extends between the cathode terminal structure 28 and the active base region 18 or, more particularly, between the cathode region 30 and the primary region 36 of the active base region 18. The gate electrode 38 is insulated from the semiconductor body 12 by an underlying insulating layer 42 which may comprise, for example, silicon dioxide or silicon nitride. The gate electrode 38 itself may, for example, comprise aluminum or highly-doped polycrystalline silicon of either conductivity type, as is known in the art.

To complete the device structure, a P+ isolation region 48 surrounds the active device regions, in accordance with a known technique for electrically isolating devices which are formed on a common $P^-$ substrate.

As will be appreciated by those skilled in the art, a number of additional details are needed to complete the device structure. For example, a passivating oxide or other insulating layer (not shown) is required over the entire exposed surface of the semiconductor body 12, rather than just in the gate insulating area 42. Similarly, a wide variety of surface geometry and interdigitation patterns may be employed. Also, as noted above, the IGR 10 may be viewed as a single unit cell of an overall device structure. Further, various techniques may be employed to contact the cathode electrode 32 and the gate electrode 38. FIG. 1 implies individual patterned metal electrode areas on the surface of the device 10. However, completely encased gate electrode 38 structures may be employed, with remote gate contacts (not shown), in combination with cathode metallization covering the entire visible surface of the device 10.

In operation, upon biasing the gate electrode 38 with a positive voltage with respect to cathode 32 above a threshold value and below a positive voltage applied to the anode 24 with respect to the cathode 32, a portion of the P conductivity type shield base region 26 at the surface 14 just below the gate insulator 42 becomes "inverted", i.e., more populated by minority carriers (electrons) than majority carriers (holes). The channel portion 35 then conducts electrons from the cathode terminal structure 28 to the primary region 36 of the active base region 18. Electron current is represented by dashed line 44.

At the same time, the P+ conductivity type anode region 22 injects majority carriers (holes) into the active base region 18, some of which follow an exemplary hole current path represented by dashed line 46. electrons in the electron current path 44 recombine in the active bases region 18 with holes in the hole current path 42, thus determining the current through the IGR 10. Thus, the device 10 is a bipolar mode conduction device.

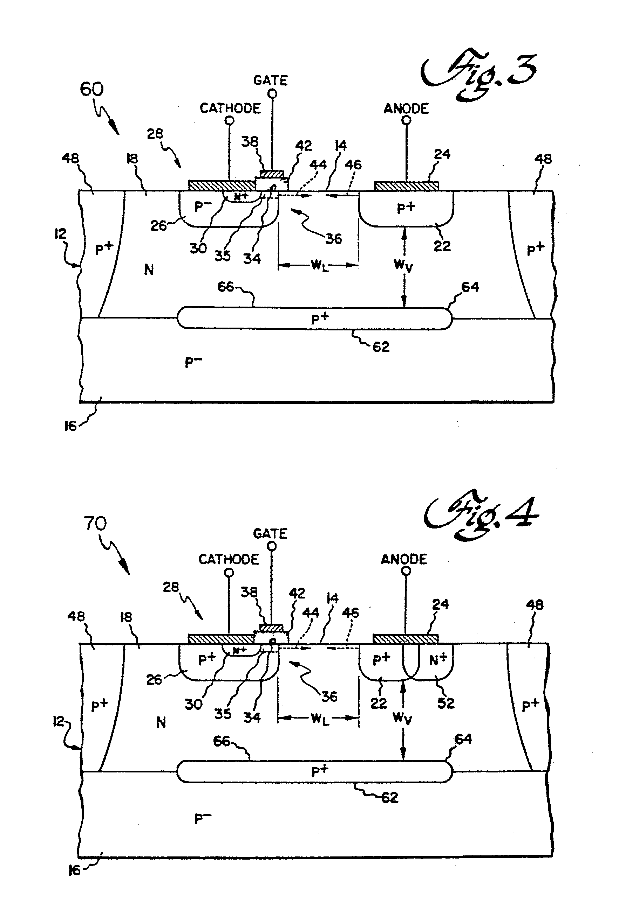

With reference now to FIG. 2, depicted is an alternative form of IGR device 50 including an anode short. In particular, an island-like N+ anode terminal short region 52 is formed in the body 12 within the active base region 18 and extending to the principal surface 14. The anode terminal electrode 24 contacts the anode shorting region 52, in addition to contacting the anode region 22 itself.

This particular anode short structure is easily fabricated by overlapping the N+ and P+ diffusions during processing by means of separate photolithographic masks.

The anode short has the effect of enhancing the turn-off speed of the IGR 50 by enabling majority carriers in the N conductivity type active base region 18 (i.e., electrons) to be rapidly drawn out of the active base region 18 and to the anode electrode 24 which, in circuit operation, would have a positive bias with respect to the cathode electrode 32. In other words, a path for rapid removal of electrons is provided such that excess majority carriers (electrons) are rapidly removed.

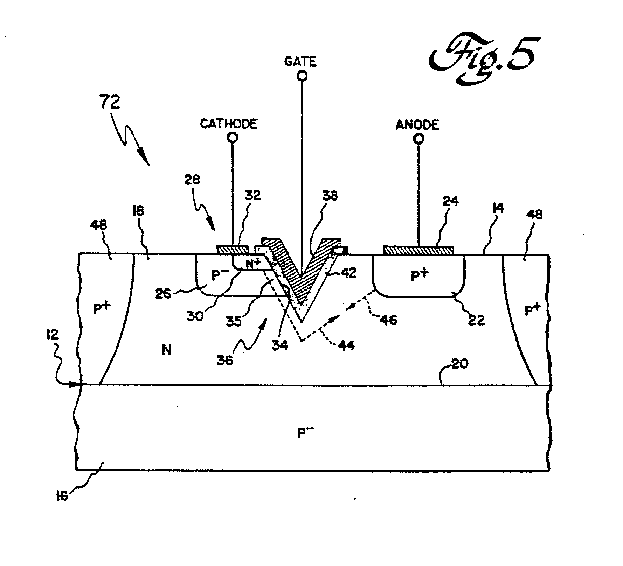

Depicted in FIG. 3 is another device structure 60 in accordance with the invention for enhanced forward current conduction. Specifically, the device 60 of FIG. 3 includes a P+ buried layer formed in the body 12 between portions of the active base region layer 18 and the substrate layer 16. The buried layer 62 generally underlies the anode terminal region 2 and the active base primary region 36. A typical doping concentration for the buried layer 62 is $10^{18}$ dopant atoms per cubic centimeter.

In operation, the P+ buried layer 62 serves to collect majority carriers (holes) injected from the anode region 22 at the P+ buried layer end 64 below the P+ anode diffusion 22, and to reinject these holes at the buried layer end 66 generally underlying the primary region 36 on the active base region 18.

The buried layer 62 can be formed employing conventional techniques. For example, a typical fabrication process begins with the substrate layer 16, and suitable impurities, i.e., dopant atoms, are introduced through a suitable mask to define the location of the buried layer 62. Thereafter, the mask is removed and the active base region layer 18 epitaxially grown over the substrate 16. As depicted, the buried layer 62 extends slightly up into the active base region 18 due to autodoping during vapor phase or liquid phase epitaxial growth. In particular, during the initial stages of epitaxial growth to form the active base region 18, some of the P+ type dopant enters the gas or liquid phase and is then deposited as part of the epitaxial layer.

FIG. 4 illustrates an insulated gate rectifier structure 70 embodying the invention and including both a P+ buried layer 62 as depicted in FIG. 3, and an anode shorting region 52 as depicted in FIG. 3.

Finally, FIG. 5 depicts a lateral insulated-gate rectifier structure 72, comparable to that of FIG. 1, but employing a "V"-groove MOS (VMOS) structure. Typically, such structures are formed on <100>-oriented silicon substrates, employing a nonisotropic etchant to form a notch or groove 74, having sides sloping at a predetermined angle (e.g. 54.7°) from the surface 14. The channel surface 34 is on a sidewall of the groove 74, rather than being at the principal surface 14, and the insulated-gate structure is formed within the groove 74. In operation, the IGR 72 of FIG. 5 functions essentially identically to the IGR 10 of FIG. 1. It will be appreciated that the devices of FIGS. 2, 3 and 4 may also be modified to comprise a VMOS structure.

In view of the foregoing, it will be appreciated that the present invention provides practical IGR device structures of lateral configuration such that all three device terminals are on one surface. As a result, the IGR may more readily be integrated with other semiconductor devices. Moreover, by the present invention there has been provided an improved lateral IGR device structure with enhanced conductivity.

While specific embodiments of the invention have been illustrated and described herein, it is realized that numerous modifications and changes will occur to those skilled in the art. For example, the invention applies to complementary devices, wherein P-type regions are used in place of the N-type regions described herein, and vice-versa. It is therefore to be understood that the appended claims are intended to cover all such modifications and changes as fall within the true spirit and scope of the invention.

**Claims**

1. An insulated-gate rectifier of lateral configuration comprising:

a body of semiconductor material having a principal surface and including an active base region of one conductivity type extending to said principal surface;

first main terminal structure including an island-like first main terminal region of opposite conductivity type formed in said body within said active base region and extending to said principal surface, and including a first terminal electrode contacting said first main terminal region;

a shield base region of opposite conductivity type formed in said body within said active base region laterally spaced from said first main terminal region;

second main terminal structure spaced from said active base region to define a channel portion in said shield base region extending between said second main terminal structure and said active base region, said second main terminal structure including a second main terminal electrode; and

an insulated gate electrode over said channel portion and configured for inducing in said channel portion, when gate voltage is applied thereto, an inversion channel region conductively coupling said second main terminal structure and said active base region;

said active base region, said shield base region, and said terminal structures being configured and arranged such that said insulated-gate rectifier supports conduction in a forward direction between said main terminal electrodes when said inversion channel region exists and such that said insulated-gate rectifier ceases to support conduction in a forward direction when said inversion channel region ceases to exist.

2. A insulated-gate rectifier in accordance with Claim 1, wherein said second main terminal structure further includes an island-like second main terminal region of the one conductivity type formed in said body within said shield base region, and wherein said second terminal electrode contacts said second main terminal region.

3. A insulated-gate rectifier in accordance with Claim 2, wherein said second terminal electrode additionally contacts said shield base region to provide a short between said second main terminal region and said shield base region.

4. A insulated-gate rectifier in accordance with Claim 1, which further comprises an island-like first terminal shorting region of the one conductivity type formed in said body within said active base region and extending to said principal surface, and wherein said first terminal electrode additionally contacts said first terminal shorting region to provide a short between said first main terminal region and said active base region.

5. A insulated-gate rectifier in accordance with Claim 2, which further comprises an island-like first terminal shorting region of the one conductivity type formed in said body within said active base region and extending to said principal surface, and wherein said first terminal electrode additionally contacts said first terminal shorting region to provide a short between said first main terminal region and said active base region.

6. An insulated-gate rectifier in accordance with Claim 2, wherein:

said active base region is of N conductivity type;

said shield base region is of P conductivity type;

said first main terminal region is of P conductivity type and constitutes an anode region of said rectifier;

said second main terminal region is of N conductivity type and constitutes a cathode region of said rectifier; and

said insulated gate electrode is configured for inducing in said channel portion an inversion channel region of N conductivity type when said gate electrode is biased positively with respect to the cathode region.

*Fig.1*

*Fig.2*

*Fig.3*

60

CATHODE    GATE    ANODE

48    18    28    38    42    14    46    24    48

26    P⁻    N⁺    44    P⁺    P⁺
12    P⁺    30    35    34    36    W_L    W_V    22    P⁺
    N

66    64
P⁺
62

P⁻

16

*Fig.4*

70

CATHODE    GATE    ANODE

48    18    28    38    42    14    45    24    48

26    P⁺    N⁺    44    P⁺    N⁺
12    P⁺    30    35    34    36    W_L    22    W_V    52    P⁺
    N

66    64
P⁺
62

P⁻

16

0273030

*Fig.5*